# EUROPEAN PATENT SPECIFICATION

(11) **EP 0 426 306 B1**
(45) Date of publication and mention of the grant of the patent: **08.06.1994**
(21) Application number: 90310835.5
(22) Date of filing: 03.10.1990
(51) Int. Cl.: H05K 7/10

(54) **IC socket**
IC-Träger
Socle de circuit intégré

(30) Priority: 30.10.1989 JP 127804/89
(43) Date of publication of application: 08.05.1991
(73) Proprietor: Yamaichi Electronics Co., Ltd., Ohta-ku Tokyo (JP)
(72) Inventor: Matsuoka, Noriyuki, Shinagawa-ku, Tokyo (JP); Uratsuji, Kazumi, Ohta-ku, Tokyo (JP)
(74) Representative: Ben-Nathan, Laurence Albert

(56) References cited:
- DE-A- 2 233 935
- US-A- 4 188 085
- US-A- 4 460 237
- US-A- 4 758 176

## Description

### BACKGROUND OF THE INVENTION

### 1. Field of the Invention

This invention relates to an IC socket having a plurality of contacts for contacting with an IC package, each of the contacts having a male terminal projecting outward.

### 2. Brief Description of the Prior Art

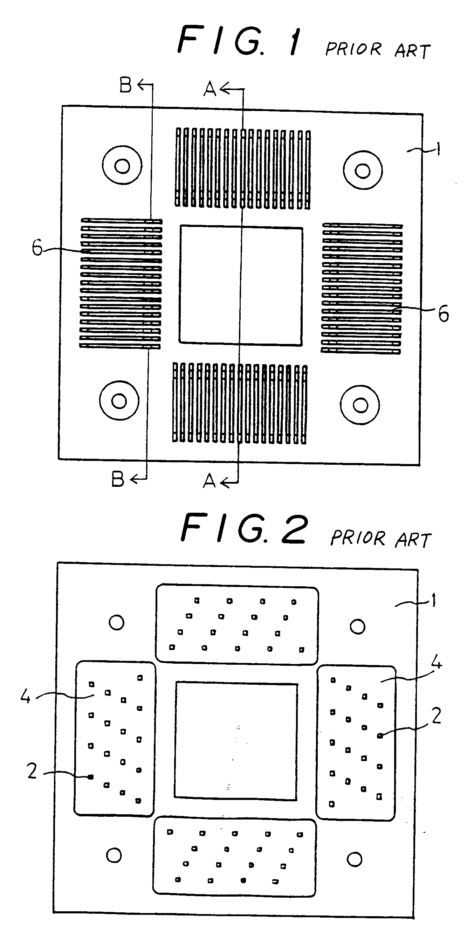

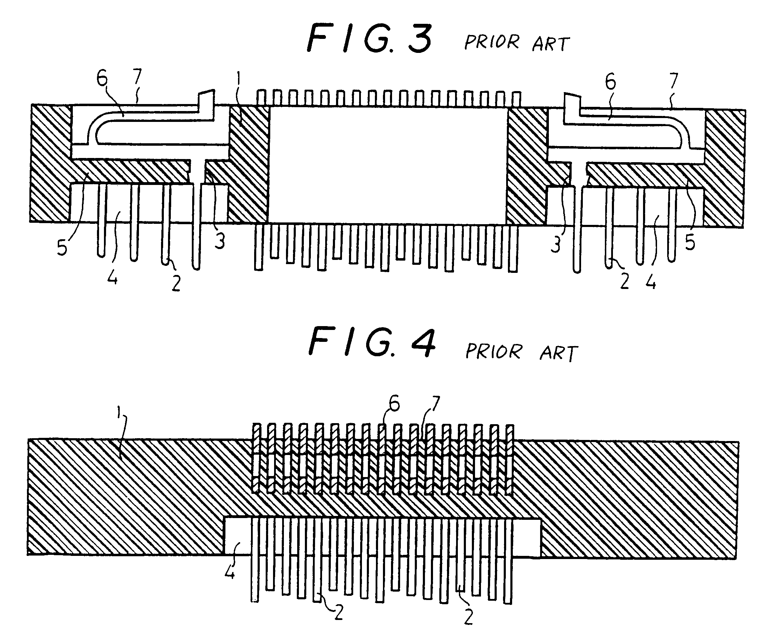

As is shown in Figs. 1 through 4, a metallic mold used for molding synthetic resin of a socket board 1 conventionally has a group of pins (not shown) for shaping grooves 3 for implanting therein the male terminals 2. For the purpose of shortening the lengths of the shaping pins to enhancing the strength thereof, an upset bottom 4 is formed in the region from where a group of male terminals of the socket board 1 project, contact partition walls 7 being integrally formed with an upper surface of a bottom wall 5 of the upset bottom 4, a contact 6 being disposed between the partition walls 7, the male terminal 2 of said contact 6 being press fitted into the implantation groove 3 so as to project from a lower surface of the bottom wall.

As mentioned above, the conventional device (see e.g. US-A-4 758 176) is provided with an upset bottom formed in the socket board at the region from where the group of male terminals project in order to enhance the strength of the shaping pins of the metallic mold for molding the group of grooves for implanting the male terminals. However, because of the foregoing arrangement, another problem arises in that the strength of the body of the socket board is deteriorated. This "lack of strength" problem becomes more and more significant with the progress of higher density of the implantation of the group of male terminals in recent time.

That is, the group of male terminals become more and more miniaturized due to the higher density of the implantation. As they become narrower and weaker than the implantation groove shaping pins, it is required to shorten the length of the male terminals in order to enhance the strength. As a result, the male terminal implantation bottom of the upset bottom, from where the group of male terminals project, is required to be formed thinner. Moreover, as the implantation grooves are formed, in high density, in the male terminal implantation wall of the upset bottom, the deterioration in strength is much enhanced. Thus, an immediate solution is definitely demanded.

Also, in order to supplement the deterioration of the strength, the entire frame portion at the peripheral edge of a socket board is conventionally increased in thickness or otherwise a reinforcement rib or ribs are formed there. However, this kind of solution invites an increased size of the socket board and this is apparently against the demand for miniaturization of socket boards.

### SUMMARY OF THE INVENTION

The present invention has been accomplished in order to solve the above problems inherent in the prior art.

It is therefore an object of the present invention to provide an IC socket capable of effectively solving the above problems without necessity for making the IC socket large in size and while properly maintaining an upsetting amount of an upset bottom from where male terminals project.

To achieve the above object, there is provided an IC socket according to claim 1, provided with an upset bottom formed in a socket board at a region from where a group of male terminals project, comprising terminal partition walls arranged in a lattice shape and adapted to partition the interior of said upset bottom, and a group of grooves formed between said adjacent terminal partition walls, said group of male terminals projecting from bottom walls of said grooves.

From another aspect of the present invention, there is also provided an IC socket according to claim 2, provided with an upset bottom formed in a socket board at a region from where a group of male terminals project, comprising terminal partition walls adapted to partition the interior of said upset bottom, said partition walls being leaned relative to each other to form a mesh-like configuration, and grooves defined by said mesh-like terminal partition walls, said group of male terminals projecting from bottom walls of said grooves.

According to the present invention having the above-mentioned construction, by virtue of the provision of the terminal partition walls for partitioning the upset bottom at a region from where the male terminals project in a lattice shape or the terminal partition walls leaned in a mesh-like configuration, it provides substantially the same effect as if the upset bottom is substantially increased in thickness. Moreover, as the above-mentioned effect can be obtained while maintaining a proper upsetting amount required for forming the implantation grooves for the male terminals, it works very effectively as means for coping with deterioration of the strength of the socket board caused by the upset bottom.

Furthermore, as the shaping pins for the male terminal implantation grooves can be made short by increasing the upsetting amount, it can be of great help for shaping the male terminal implantation grooves in high density.

The above and other objects, characteristic features and advantages of the present invention will become more manifest to those skilled in the art upon reading of the following detailed description of the preferred embodiment with reference to the accompanying drawings.

### BRIEF DESCRIPTION OF THE DRAWINGS

Fig. 1 is a plan view of a conventional socket board;
Fig. 2 is a bottom view thereof;
Fig. 3 is a sectional view taken on line A-A of Fig. 1; and
Fig. 4 is a sectional view taken on line B-B of Fig. 1.
Fig. 5 is a bottom view of a socket board according to one embodiment of the present invention;
Fig. 6 is a sectional view taken on line C-C of Fig. 5;
Fig. 7 is a sectional view taken on line D-D of Fig. 5;
Fig. 8 is a bottom view of a socket board according to another embodiment of the present invention; and
Fig. 9 is a bottom view of a socket board according to a further embodiment of the present invention.

### DETAILED DESCRIPTION OF THE EMBODIMENT

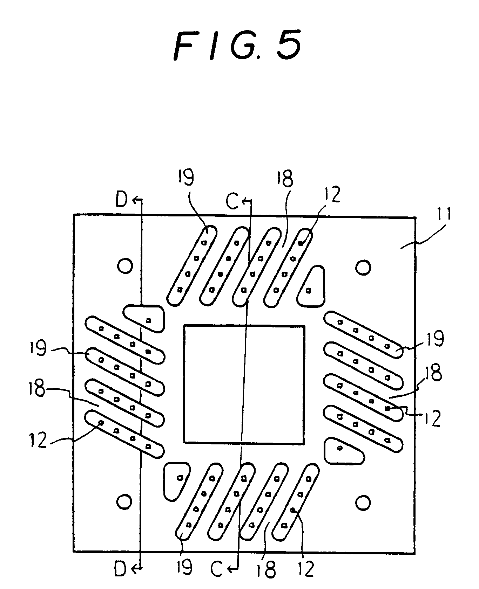

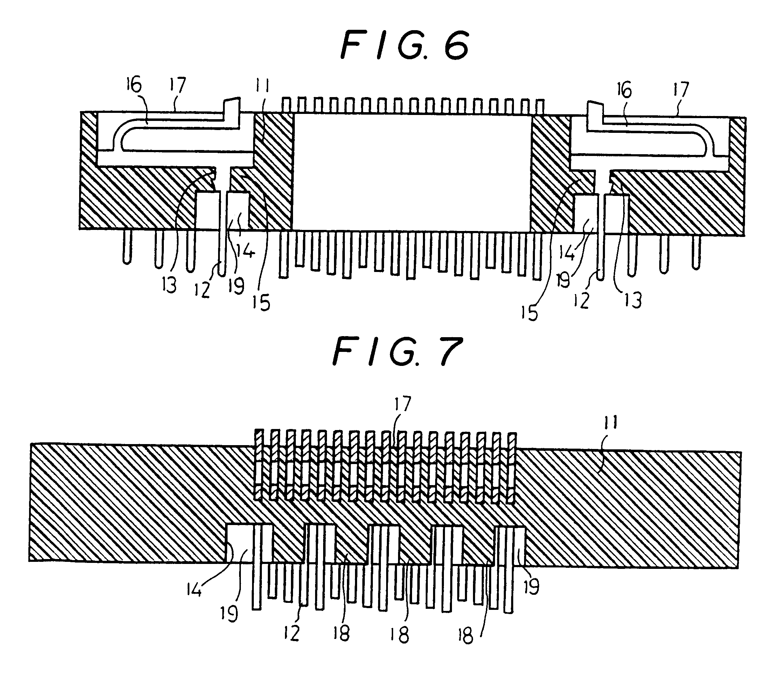

The embodiments of the present invention will be described hereunder with reference to Figs. 5 through 9 of the accompanying drawings.

A socket board 11, as in the prior art of Fig. 1, has a plurality of connector contacts 16 arranged to contact with an IC package.

Each of the connector contacts 16 has a male terminal 12 projecting outward from the socket board 11 so that the male terminal 12 can be connected to a printed circuit board or the like.

The socket board 11 is provided with an upset bottom 14 formed in the socket board 11 at a region from where the male terminals project, the upset bottom 14 being partitioned by a terminal partition wall 18, a group of the male terminals 12 projecting from bottom walls 15 of a group of grooves 19 defined between the terminal partition wall 18 group. A single or plurality of the male terminals 12 are distributed in each groove 19.

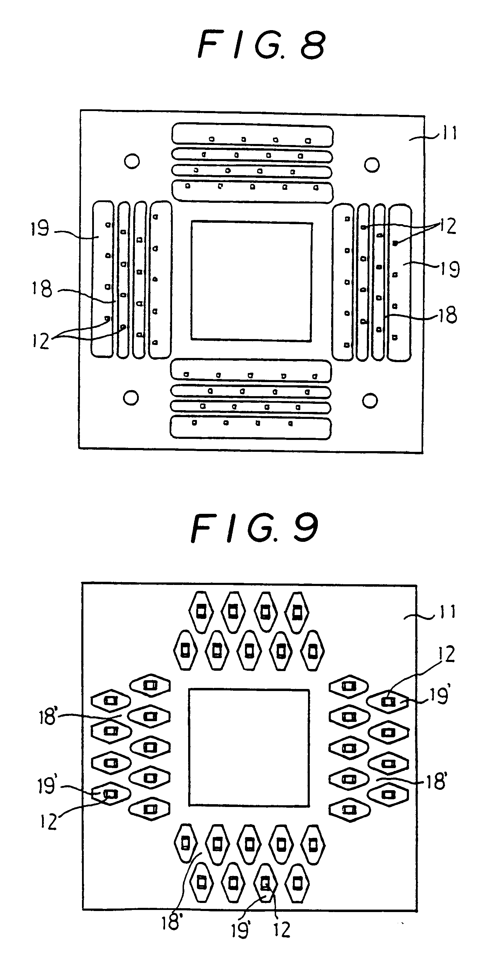

The upset bottom 14 is partitioned by the terminal partition walls 18 in a slant lattice (see Figs. 5 through 7), or in a vertical and/or horizontal lattice (see Fig. 8), or these terminal partition walls 18 are properly combined so that an elongate groove 19 is formed between the adjacent lattice-shaped terminal partition walls 18, and one row portion of the male terminals 12 are distributed in each groove 19, the male terminal 12 group is partitioned by the terminal partition wall 18 per each row and allowed to project downward from the lower surface of the bottom wall 15.

On the other hand, a contact partition wall 17 is integrally formed on the upper surface of the bottom wall 15, the contact 16 is disposed between the adjacent contact partition walls 17, and the male terminal 12 is implanted, under pressure, into the terminal implantation groove 13 formed in the bottom wall 15 and allowed to project into each groove 19 from the lower surface of the bottom wall 15.

By this, the bottom wall 15 is provided with the contact partition wall 17 integrally formed on the upper surface thereof and with the terminal partition wall 18 integrally formed on the lower surface thereof, both the partition walls 17 and 18 being disposed in such a manner as to be intersected with each other. In the embodiment shown in Figs. 5 through 7, the terminal partition wall 18 is disposed at angles relative to the contact partition wall 17.

In another embodiment shown in Fig. 8, the terminal partition walls 18 are disposed in a horizontal lattice shape and are perpendicular to the contact partition walls 17.

In the embodiments shown in Figs. 5 through 7 and in Fig. 8, two rows or more of the male terminals can be disposed in the groove 19 between the adjacent lattice-shaped terminal partition walls 18. Also, the male terminal 12 group can be divided into a plurality of groups and disposed in each groove in various forms.

In a further embodiment shown in Fig. 9, the interior of the upset bottom 14 is formed in a partition wall structure leaning in a mesh-like configuration and the male terminal 12 group are allowed to project from the bottom walls of the groove 19′ group defined by the terminal partition wall 18′.

One each of the male terminals 12 is disposed in the groove 19′ and the inner portion of each terminal 12 is surrounded by the partition walls 18′.

In this embodiment, as the terminal partition walls 18 leaned in a mesh-like configuration, they are intersected with the contact partition walls 17 in various directions.

In any of the above embodiments, the male terminal implantation grooves 13 are formed in the bottom wall 15 of the grooves between the adjacent partition walls by short metallic male terminal shaping pins.

As described in the foregoing, the present invention exhibits substantially the same effect as the upset bottom is substantially increased in thickness by terminal partition walls partitioning the upset bottom in a lattice shape at a region from where the male terminal group project or by terminal partition walls leaned in a mesh-like configuration, without increasing the size of the IC socket. The foregoing effect can be expected while properly maintaining an upsetting amount required for forming the male terminal implantation grooves. Thus, this is very effective as means for coping with the deterioration in strength of the socket board caused by the upset bottom. Also, the lengths of the pins for shaping the male terminal implantation grooves can be shortened by increasing the upsetting amount of the grooves. Accordingly, this is very advantageous for forming the male terminal implantation grooves in high density and can effectively cope with the requirement for forming the male terminals in high density in an IC socket.

Although the present invention has been herein shown and described in what is conceived to be the most practical and preferred embodiments, it is recognized that departures may be made therefrom within the scope of the claims.

## Claims

1. An IC socket provided with an upset bottom (14) formed in a socket board (11) at a region from where a group of male terminals (12) project outward, characterized by terminal partition walls (18) arranged in a lattice shape and adapted to partition the interior of said upset bottom (14) at said region, and a group of grooves (19) formed between adjacent terminal partition walls, said group of male terminals (12) projecting from bottom walls of said grooves (19).

2. An IC socket provided with an upset bottom (14) formed in a socket board (11) at a region from where a group of male terminals (12) project outward, characterized by terminal partition walls (18′) adapted to partition the interior of said upset bottom (14) at said region, said partition walls (18′) being disposed relative to each other to form a mesh-like configuration, and grooves (19′) defined by said mesh-like terminal partition walls (18′), said group of male terminals (12) projecting from bottom walls of said grooves (19′).

3. An IC socket according to Claim 1 or Claim 2, wherein contact partition walls (17), separating contacts (16) with which said male terminals (12) are associated, are integrally formed on the upper surface of said upset bottom (14) and are arranged to intersect said terminal partition walls (18), when the socket is viewed in plan.

4. An IC socket according to Claims 1 and 3 wherein said contact and terminal partition walls (17,18) intersect one another at right angles.

5. An IC socket according to Claims 1 and 3, wherein said contact and terminal partition walls (17,18) intersect one another at acute angles.

## Patentansprüche

1. IC-Stecker, dessen Korpus (11) an der Unterseite im Bereich der aus dem Stecker vorspringenden Steckerstifte (12) einen Rücksprung (34) aufweist, gekennzeichnet durch vom Boden des Rücksprungs (14) ausgehende, in einer gitterartigen Konfiguration zueinander verlaufende, Gruppen von Steckerstiften (12) aufnehmenden Kammern (19) ausbildende Wandungen (18) und aus den Böden der Kammern (19) gruppenweise vorspringende sich durch die Kammern (19) erstreckende Steckerstifte (12).

2. IC-Stecker, dessen Korpus (11) an der Unterseite im Bereich der über den Stecker vorspringenden Steckerstifte (12) einen Rücksprung aufweist, gekennzeichnet durch vom Boden des Rücksprungs ausgehend in einer netzartigen Konfiguration zueinander angeordnete Kammern (19′) ausbildend, ineinander übergehende Wandungen (18′) und aus den Böden der Kammern (19′) vorspringende sich durch die Kammern (19) erstreckende Steckerstifte (12).

3. IC-Stecker nach Anspruch 1 oder Anspruch 2, dadurch gekennzeichnet, daß die mit den Steckerstiften (12) zusammengefaßten Kontakte (16) des IC-Steckers gegeneinander durch Wandungen (17) abgeschirmt sind, die am Steckerkorpus (11) ausgebildet, die steckerstiftseitigen Wandungen (18) in Draufsicht kreuzend.

4. IC-Stecker nach Anspruch 3, dadurch gekennzeichnet, daß die kontaktseitigen Wandungen (17) und die steckerstiftseitigen Wandungen (18) sich in Draufsicht auf den Stecker unter einem rechten Winkel kreuzen.

5. IC-Stecker nach Anspruch 3, dadurch gekennzeichnet, daß die kontaktseitigen Wandungen (17) und die steckerstiftseitigen Wandungen (18) ich in Draufsicht auf den Stecker unter einem spitzen Winkel kreuzen.

## Revendications

1. Socle de circuit intégré muni d'un fond renversé (14) formé dans une plaquette de socle (11) dans une zone d'où part vers l'extérieur un groupe de bornes mâles (12), caractérisé en ce qu'il comprend des cloisons de séparation de bornes (18) disposées en forme de treillis et destinées à cloisonner l'intérieur du fond renversé (14) à l'endroit de cette zone, et un groupe de rainures (19) formées entre ces cloisons de séparation de bornes adjacentes, le groupe de bornes mâles (12) faisant saillie sur les parois de fond des rainures (19).

2. Socle de circuit intégré muni d'un fond renversé (14) formé dans une plaquette de socle (11) dans une zone d'où part vers l'extérieur un groupe de bornes mâles (12), caractérisé en ce qu'il comprend des cloisons de séparation de bornes (18') destinées à cloisonner l'intérieur du fond renversé (14) à l'endroit de cette zone, les cloisons de séparation (18') étant disposées les unes par rapport aux autres de manière à former une configuration en forme de mailles, et des rainures (19') définies par les cloisons de séparation de bornes en forme de mailles (18'), le groupe de bornes mâles (12) faisant saillie sur les parois de fond des rainures (19').

3. Socle de circuit intégré selon l'une quelconque des revendications 1 et 2, caractérisé en ce que des cloisons de séparation de contacts (17), séparant des contacts (16) avec lesquels sont associées les bornes mâles (12), sont formées d'un seul tenant sur la surface supérieure du fond renversé (14) et sont disposées de manière à couper les cloisons de séparation de bornes (18), lorsqu'on regarde le socle dans une vue en plan.

4. Socle de circuit intégré selon les revendications 1 et 3, caractérisé en ce que les cloisons de séparation de contacts et de bornes (17, 18) se coupent les unes les autres à angle droit.

5. Socle de circuit intégré selon les revendications 1 et 3, caractérisé en ce que les cloisons de séparation de contacts et de bornes (17, 18) se coupent les unes les autres sous des angles aigus.
